(19)

Europäisches Patentamt
European Patent Office
Office européen des brevets

(11)  **EP 4 739 056 A1**

(12)  **EUROPEAN PATENT APPLICATION**
published in accordance with Art. 153(4) EPC

(43) Date of publication:
06.05.2026  Bulletin 2026/19

(21) Application number: 24943670.0

(22) Date of filing: 19.09.2024

(51) International Patent Classification (IPC):
*H10K 59/40* (2023.01)      *H10K 59/126* (2023.01)
*H10K 59/131* (2023.01)

(86) International application number:
PCT/CN2024/119612

(87) International publication number:
WO 2026/044843 (05.03.2026 Gazette 2026/10)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority:  29.08.2024  CN 202411204925

(71) Applicant: Wuhan Tianma Microelectronics Co.,
Ltd.
Wuhan, Hubei 430205 (CN)

(72) Inventors:
• LUO, Lisha
  Wuhan, Hubei 430205 (CN)
• YANG, Yuehua
  Wuhan, Hubei 430205 (CN)
• ZHOU, Shu
  Wuhan, Hubei 430205 (CN)
• YU, Chao
  Wuhan, Hubei 430205 (CN)

(74) Representative: Germain Maureau
12, rue Boileau
69006 Lyon (FR)

(54)  **DISPLAY PANEL AND DISPLAY APPARATUS**

(57)    The present disclosure provides a display panel and a display apparatus and relates to the field of display technologies. The display panel includes: a display region and a non-display region disposed outside the display region, wherein the non-display region includes a step region and a non-step region, the step region includes a trace region and a function region arranged along a first direction, and a bonding pin is located in the function region; a touch electrode and a touch-signal line electrically connected to the touch electrode, wherein the touch-signal line extends from the trace region to the function region and is electrically connected to the bonding pin; and a first signal line located in the function region and configured to transmit an alternating current signal; wherein along a second direction, the first signal line at least partially overlaps with the touch control trace, the touch control trace is a part of the touch-signal line located in the function region, the first signal line and the touch control trace are isolated by a first shielding portion in a region in which the first signal line and the touch control trace overlap, the first shielding portion is configured to receive a fixed potential, and the second direction is perpendicular to a light-emitting surface of the display panel.

Fig. 3

EP 4 739 056 A1

**Description**

The present application claims priority to Chinese Patent Application No. 202411204925.8, titled "DISPLAY PANEL AND DISPLAY APPARATUS", filed before China National Intellectual Property Administration on August 29, 2024, the entireties of which are incorporated herein by reference.

**TECHNICAL FIELD**

The present disclosure relates to the field of display technologies, and in particular, to a display panel and a display apparatus.

**BACKGROUND**

With the continuous development of science and technology, an increasing number of display products, such as mobile phones, tablet computers, notebook computers, and smart wearable devices, have been widely used in people's daily life and work, bringing great convenience to people's daily life and work and becoming indispensable important tools for people nowadays.

For a display product with a touch control function, how to reduce or avoid the interference of other signals in the display product on a touch control signal and improve the touch control accuracy has become one of the technical problems to be urgently solved at the present stage.

**SUMMARY**

In order to solve the above-mentioned technical problems, the present disclosure provides a display panel and a display apparatus, aiming to reduce or avoid the interference of other signals in the display panel on a touch control signal and improve the touch control accuracy.

In a first aspect, embodiments of the present disclosure provide a display panel, including: a display region and a non-display region disposed outside the display region, where the non-display region comprises a step region and a non-step region, the step region comprises a trace region and a function region that are arranged along a first direction, and a bonding pin is located in the function region; a touch electrode and a touch-signal line electrically connected to the touch electrode, where the touch-signal line extends from the trace region to the function region and is electrically connected to the bonding pin; and a first signal line located in the function region, wherein the first signal line is configured to transmit an alternating current signal; where along a second direction, the first signal line at least partially overlaps with a touch control trace, the touch control trace is a part of the touch-signal line located in the function region, the first signal line and the touch control trace are isolated by a first shielding portion in a region in which the first signal line and the touch control trace overlap, the first shielding portion is configured to receive a fixed potential, and the second direction is perpendicular to a light-emitting surface of the display panel.

In a second aspect, based on the same inventive concept, embodiments of the present disclosure further provide a display apparatus, including the display panel provided in the first aspect of the present disclosure.

Compared with the related art, the technical solutions provided by the embodiments of the present disclosure have the following advantages:

In the display panel and the display apparatus provided by the present disclosure, the touch-signal line connected to the touch electrode extends to the function region and is electrically connected to the bonding pin in the function region. In addition to the touch-signal line, some other signal lines in the display panel (such as the first signal line mentioned in the present disclosure) may also be led to the function region and are electrically connected to other bonding pins in the function region. Where the first signal line includes a signal line for transmitting an alternating current signal in the function region, for example, a signal line for transmitting a data signal, a signal line for transmitting a clock signal, etc. The signals transmitted by these signal lines are not constant direct current signals but alternating current signals with abrupt transitions. In the function region, due to the dense wiring, the touch control trace and the first signal line may overlap each other. Since the signal transmitted on the first signal line is an alternating current signal, when the signal on the first signal line changes abruptly, a signal on the touch control trace may also change abruptly due to the coupling effect, which can affect the accuracy of a touch control signal transmitted on the touch control trace and the touch control accuracy. Therefore, in the present disclosure, the first shielding portion is provided in the overlapping region of the first signal line and the touch control trace. A signal on the first shielding portion is the fixed potential. With the first shielding portion, the signal coupling between the first signal line and the touch control trace can be shielded, which is beneficial to reducing or avoiding the influence of the abrupt signal change on the first signal line on the touch signal on the touch control trace, and in turn is beneficial to improving the touch control accuracy.

**BRIEF DESCRIPTION OF DRAWINGS**

The drawings herein, which are incorporated into the specification and constitute a part of the specification, show the embodiments conforming to the present disclosure, and are used together with the specification to explain the principles of the present disclosure.

In order to more clearly illustrate the technical solutions in the embodiments of the present disclosure or in the related art, the drawings required to be used in the description of the embodiments or the related art will be briefly introduced below. Apparently, for those of ordinary skill in the art, other drawings can also be obtained according to these drawings without creative efforts.

FIG. 1 is a planar structural diagram of a display panel provided by an embodiment of the present disclosure.

FIG. 2 is a connection schematic diagram of a touch electrode and a touch-signal line in a display panel provided by an embodiment of the present disclosure.

FIG. 3 is an enlarged schematic diagram of a region A in FIG. 1.

FIG. 4 is a schematic diagram of a pixel arrangement in a display panel provided by an embodiment of the present disclosure.

FIG. 5 is a cross-sectional view along a direction AA of the display panel in FIG. 4.

FIG. 6 is a top view of a touch-signal line, a power line, and a first signal line.

FIG. 7 is a schematic diagram of film layers along a direction BB of FIG. 6.

FIG. 8 is a wiring schematic diagram of a data line in a display panel provided by an embodiment of the present disclosure.

FIG. 9 is another enlarged schematic diagram of the region A in FIG. 1.

FIG. 10 is another enlarged schematic diagram of the region A in FIG. 1.

FIG. 11 is another enlarged schematic diagram of the region A in FIG. 1.

FIG. 12 is a relative positional relationship of a touch control trace, a first signal line, and a first shielding portion in a function region.

FIG. 13 is a wiring schematic diagram of a body portion, a first branch, and a second branch in a touch control trace of a function region in FIG. 9, FIG. 10, or FIG. 11.

FIG. 14 is a top view of second shielding portions disposed between first branch lines and second branch lines.

FIG. 15 is another top view of second shielding portions arranged between first branch lines and second branch lines.

FIG. 16 is another wiring schematic diagram of a body portion, a first branch, and a second branch in a touch control trace in a function region.

FIG. 17 is another top view of second shielding portions arranged between first branch lines and second branch lines.

FIG. 18 is a schematic diagram of film layers in a function region of a display panel provided in the present disclosure.

FIG. 19 is another schematic diagram of film layers in a function region of a display panel provided in the present disclosure.

FIG. 20 is a wiring schematic diagram of a first branch line at a junction between a jumper-wire region and a first region.

FIG. 21 is a comparative schematic diagram corresponding to FIG. 20.

FIG. 22 is a top view of a slope and a first branch line.

FIG. 23 is a cross-sectional view along a direction CC corresponding to a structure in FIG. 22.

FIG. 24 is another top view of a slope and a first branch line.

FIG. 25 is a structural schematic diagram of a display apparatus provided by an embodiment of the present disclosure.

## DESCRIPTION OF EMBODIMENTS

In order to enable a clearer understanding of the above-mentioned objectives, features, and advantages of the present disclosure, the solutions of the present disclosure will be further described below. It should be noted that the embodiments of the present disclosure and the features in the embodiments can be combined with each other without conflict.

In the following description, many specific details are set forth to provide a thorough understanding of the present disclosure. However, the present disclosure can also be implemented in other ways different from those described herein. Apparently, the embodiments in the specification are only some, not all, of the embodiments of the present disclosure.

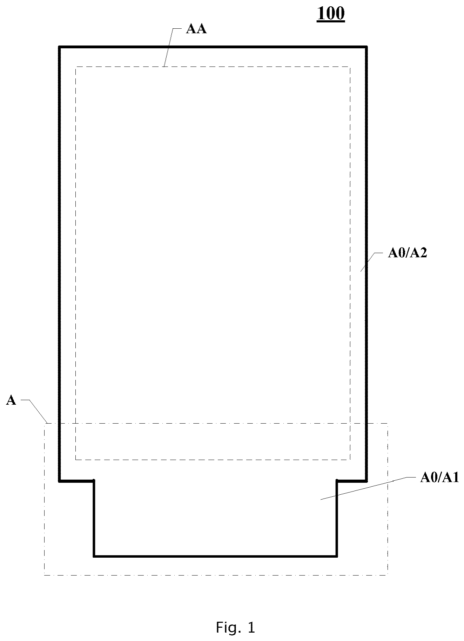

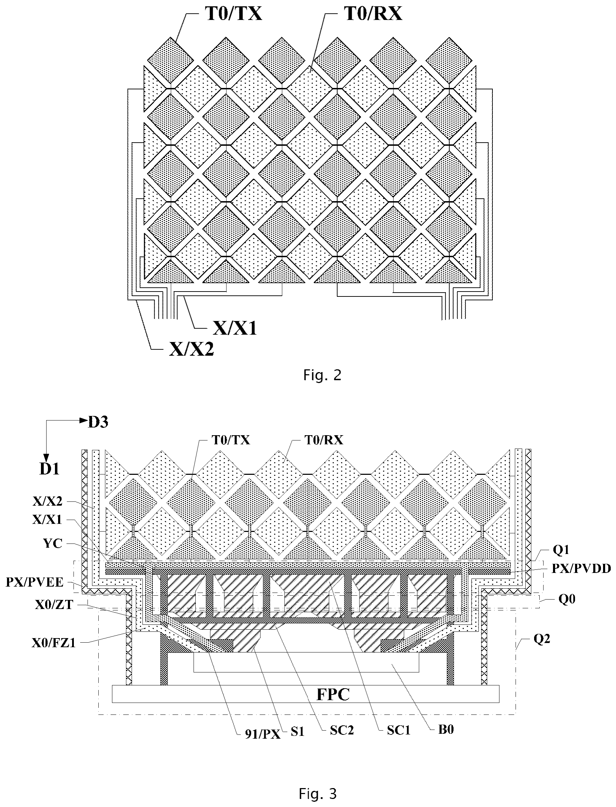

FIG. 1 is a planar structural diagram of a display panel provided by an embodiment of the present disclosure, FIG. 2 is a connection schematic diagram of a touch electrode T0 and a touch-signal line X in a display panel provided by an embodiment of the present disclosure, and FIG. 3 is an enlarged schematic diagram of a region A in FIG. 1.

Referring to FIGS. 1 to 3, the present disclosure provides a display panel 100, including a display region AA and a non-display region A0 disposed outside the display region AA. The non-display region A0 includes a step region A1 and a non-step region A2. The step region A1 includes a trace region Q1 and a function region Q2 arranged along a first direction D1, and the function region Q2 is provided with a bonding pin B0. The first direction D1 is a direction from the display region AA to the step region A1. Optionally, the step region A1 is located on one side of the display region AA along the first direction D1, and the non-step region A2 can be regarded as other bezel regions of the display panel except the step region A1, for example, including a left bezel, a right bezel, and an upper bezel.

The display panel 100 further includes a touch electrode T0 and a touch-signal line X electrically connected to the touch electrode T0. The touch-signal line X extends from the trace region Q1 to the function region Q2 and is electrically connected to the bonding pin B0. A part of the touch-signal line X located in the function region Q2 is a touch control trace X0. Optionally, the touch electrode T0 is a mutual-capacitance touch electrode as shown in FIG. 2, including a touch sensing electrode RX and touch driving electrode TX. The touch-signal line X includes a touch-signal line X1 connected to the touch driving electrode TX and a touch-signal line X2 connected to the touch sensing electrode RX. The embodiment takes the solution in which the touch-signal line X1 extends from below the display region to the step region and the touch-signal line X2 extends from the non-step region to below the display region and then extends to the step region as an example for illustration, but the present disclosure is not limited thereto. In some other embodiments of the present disclosure, both the touch-signal lines X1 and X2 can also directly pass below the display region and extend to the step region. In some other embodiments of the present disclosure, the touch electrode can also be embodied as a self-capacitance touch electrode, and the touch-signal line is a signal line connected to the self-capacitance touch electrode.

The display panel further includes a first signal line S1. The first signal line S1 is located in the function region Q2 and is configured to transmit an alternating current signal. The first signal line S1 is, for example, a signal line that provides a signal required for display to a circuit in the display panel in order to realize a display function, for example, at least one of a data line, a clock signal line, a gate driving signal line, and a light-emitting control signal line, and the like.

Along a second direction, the first signal line S1 at least partially overlaps with the touch control trace X0. The first signal line S1 and the touch control trace X0 is isolated by a first shielding portion 91 in a region in which they overlap. The first shielding portion 91 is configured to receive a fixed potential, and the second direction is perpendicular to a light-emitting surface of the display panel.

It should be noted that FIGS. 1 and 2 merely take a display panel with a rectangular structure as an example for illustration, and do not limit the actual shape of the display panel. In some other embodiments of the present disclosure, the display panel can also be embodied in any other feasible structures, such as a rounded rectangle, a circle, etc. Optionally, the step region A1 in the present disclosure further includes a bendable region Q0. The bendable region Q0 is located between the trace region Q1 and the function region Q2. The function region Q2 is bent to one side of the display panel facing away from the light-emitting surface through the bendable region Q0. The function region Q2 can be bent toward a non-light-emitting surface of the display panel using the bendable region Q0 to reduce the width of a lower bezel of the display panel and achieve a narrow-bezel effect. It should be noted that the embodiments in FIGS. 1 and 3 merely show the solution in which the display panel has not been bent yet.

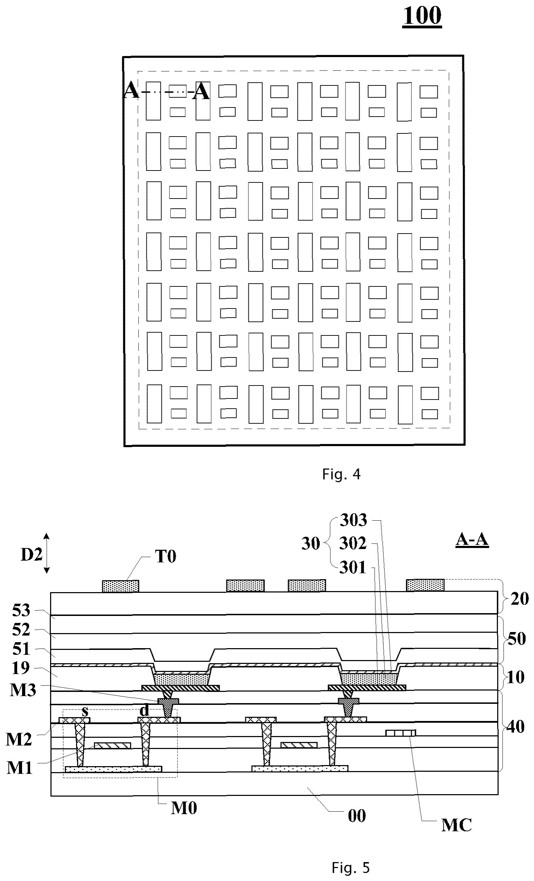

Optionally, the display panel provided by the embodiments can be a display panel using organic light-emitting diode display technology, i.e., an organic light-emitting diode (OLED) display panel, for example, referring to FIGS. 4 and 5, where FIG. 4 is a schematic diagram of a pixel arrangement in a display panel provided by an embodiment of the present disclosure, and FIG. 5 is a cross-sectional view along a direction AA of the display panel in FIG. 4. It should be noted that the pixel arrangement structure shown in FIG. 4 is merely for illustration, and does not limit the actual pixel arrangement manner and the number of pixels included in the display panel. Referring to FIG. 5, a basic structure of a light-emitting element 30 of the OLED display panel includes an anode 301, a light-emitting material layer 302, and a cathode 303. When a suitable voltage is supplied by a power source, the holes in the anode 301 and the electrons in the cathode 303 can combine in the light-emitting material layer 302 to generate light. Compared with a thin-film field-effect transistor liquid crystal display, the OLED display panel has the characteristics of high visibility and high brightness, and is more power-saving, light in weight, and thin in thickness. Of course, in some other embodiments of the present disclosure, the display panel can also be a display panel using inorganic light-emitting diode display technology, for example, a Micro LED display panel, or a Mini LED display panel, etc., and the present disclosure is not limited thereto.

Taking the display panel in FIGS. 4 and 5 as an example, a display layer 10 includes a pixel definition layer 19. The pixel definition layer 19 defines a plurality of pixel openings. The light-emitting material layer 302 is at least located in the pixel openings. Along the second direction D2, the anode 301 and the cathode 303 are respectively located on two sides of the light-emitting material layer 302, and the anode 301 is located on one side of the cathode 303 facing a substrate 00. Optionally, an encapsulation layer 50 is further provided on one side of the cathode 303 away from the anode 301, and the touch electrode T0 is located on one side of the encapsulation layer 50 facing away from the cathode 303. Optionally, the encapsulation layer 50 includes a first inorganic layer 51, an organic layer 52, and a second organic layer 53 that are stacked. The display panel further includes a driving layer 40 disposed between the substrate 00 and the display layer 10. A driving circuit is disposed in the driving layer 40 for providing a driving voltage to the display layer 10 to drive the display layer 10 to emit light. The driving circuit includes a plurality of transistors M0.

Further referring to FIGS. 2 and 3, the touch-signal line X connected to the touch electrode T0 extends to the function region Q2 and is electrically connected to the bonding pin B0 in the function region Q2. Optionally, the bonding pin B0 is used for bonding a driving chip, which may be, for example, a chip integrating a touch control driving chip and a display driving chip. In addition to the touch-signal line X, some other signal lines in the display panel (such as the first signal line S1 mentioned in this embodiment) are also led to the function region Q2 and electrically connected to other bonding pins B0 therein. The first signal line S1 includes signal lines in the function region Q2 for transmitting alternating current signals, such as a data signal transmission line, a clock signal transmission line, etc. The signals transmitted by these signal lines are not constant direct current signals but alternating current signals with abrupt transitions. In the function region Q2, due to the dense wiring, the touch control trace X0 and the first signal line S1 may overlap each other. Since the signal transmitted on the first signal line S1 is an alternating current signal, when the signal on the first signal line S1 changes abruptly, a signal on the touch control trace X0 may also change abruptly due to the coupling effect, which can affect the accuracy of a touch control signal transmitted on the touch control trace X0 and the touch control accuracy. Therefore, in the present disclosure, the first shielding portion 91 is provided in the region in which the first signal line S1 and the touch control trace X0 overlap. A signal on the first shielding portion 91 is the fixed potential. With the first shielding portion 91, the signal coupling between the first signal line S1 and the touch control trace X0 can be shielded, which is beneficial to reducing or avoiding the influence of the abrupt signal change on the first signal line S1 on the touch signal on the touch control trace X0, and in turn is beneficial to improving the touch control accuracy.

It should be noted that for the touch-signal line X, only different fillings are used to illustrate the touch-signal lines X1 and X2 in FIG. 3. Actually, the touch-signal lines X1 and X2 shown in FIG. 3 respectively include a plurality of mutually independent touch-signal lines as shown in FIG. 2. The illustration in FIG. 3 is merely to more clearly reflect the arrangement of the touch-signal lines in the display panel.

Further referring to FIG. 3, in an optional implementation of the present disclosure, the display panel further includes a power line PX. The power line PX is configured to provide a direct-current power supply to the display region AA. In the function region Q2, the power line PX is reused as the first shielding portion 91.

Taking an OLED display panel as an example, when a light-emitting element is driven to emit light by a pixel driving circuit, both the pixel driving circuit and the light-emitting element are electrically connected to the power line PX. The power line PX includes a positive power line PVDD and a negative power line PVEE. Optionally, a negative electrode of the light-emitting element is connected to the negative power line PVEE, a positive electrode of the light-emitting element is connected to the pixel driving circuit, and the pixel driving circuit is connected to the positive power line PVDD. The signal transmitted on the power line PX is a constant direct-current power supply. For the specific structure of the pixel driving circuit, reference may be made to the structure in the related art, and the present disclosure does not limit this. In the display panel, the power line PX extends from the display region AA to the function region Q2 and transmits the power supply signal to the display region AA after obtaining the power supply signal through the function region Q2. For example, the power line PX can be electrically connected to a flexible circuit board FPC in the function region Q2 and obtain the power supply signal through the flexible circuit board FPC. In the function region Q2, in the present disclosure, the power line PX is reused as the first shielding portion 91 for shielding the signal coupling between the first signal line S1 and the touch control trace X0. In this way, there is no need to provide a new film layer structure in the function region Q2 to manufacture the first shielding portion 91, which is beneficial to simplifying the manufacturing process of the display panel and improving the production efficiency of the display panel.

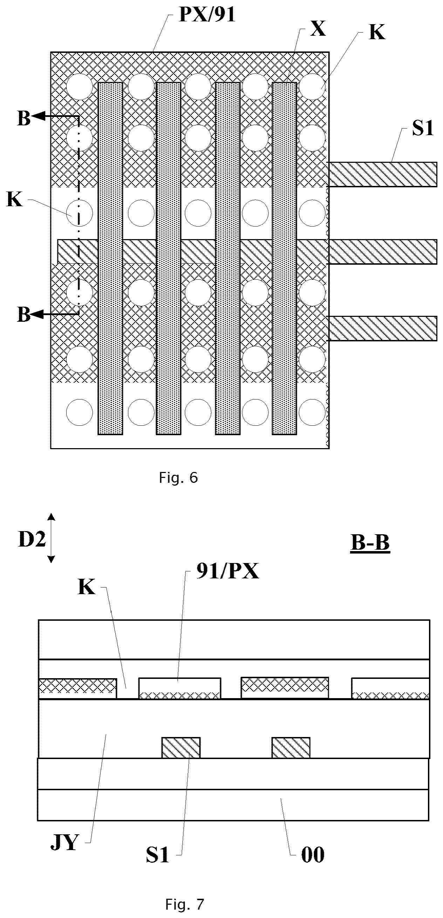

FIG. 6 is a top view of a touch-signal line X, a power line PX, and a first signal line S1, and FIG. 7 is a schematic diagram of film layers along a direction BB of FIG. 6. Referring to FIGS. 6 and 7, in an optional implementation of the present disclosure, the display panel further includes a substrate 00. The power line PX and the first signal line S1 are located on a same side of the substrate. The display panel further includes an organic insulating layer JY. The organic insulating layer JY is in contact with the power line PX and is located on one side of the power line PX facing the substrate 00. A plurality of through holes K are provided in the power line PX. Along the second direction D2, the through holes K run through the power line PX, and the through holes K do not overlap with the first signal line S1.

The organic insulating layer JY in the display panel can be, for example, a planarization layer, and the power line PX is located on one side of the organic insulating layer JY away from the substrate 00. In order to reduce the voltage drop of the power supply signal, when forming the power line PX in the function region Q2 of the display panel, if space permits, the power line PX is usually designed with a large line width, for example, in a planar structure. The organic insulating layer JY is made of an organic material. After a high-temperature process, the organic material will volatilize some water vapor and other substances. If a large area of metal covers the organic insulating layer, the volatilized substances of the organic insulating layer usually cannot penetrate the metal layer with a dense membrane, for example, the power line PX, which results in the formation of a bulge on the surface of the power line PX in an individual region, causing defects. Therefore, in the present disclosure, the plurality of through holes K are provided in the power line PX. When the organic insulating layer generates volatilized substances, the volatilized substances can volatilize through the through holes K, thereby avoiding the problem of bulging of the power line PX caused by the difficulty of volatilization of the volatilized substances. In addition, in the present disclosure, by defining that the through holes K do not overlap with the first signal line S1 along the second direction D2, the signal on the first signal line S1 can be avoided from passing through the through holes K and coupling to the touch control trace X0, so as to ensure the signal shielding effect when the power line PX is reused as the first shielding portion 91.

Further referring to FIG. 3, in an optional implementation of the present disclosure, in the function region Q2, the touch control trace X0 includes a body portion ZT and a first branch FZ1. The body portion ZT is electrically connected to the touch-signal line X, and both ends of the first branch FZ1 are electrically connected to the body portion ZT and the bonding pin B0 respectively. It should be noted that when the signal line connected to the touch electrode includes the touch-signal lines X1 and X2, the touch control traces X0 corresponding to the touch-signal lines X1 and X2 can each include the body portion ZT and the first branch FZ1.

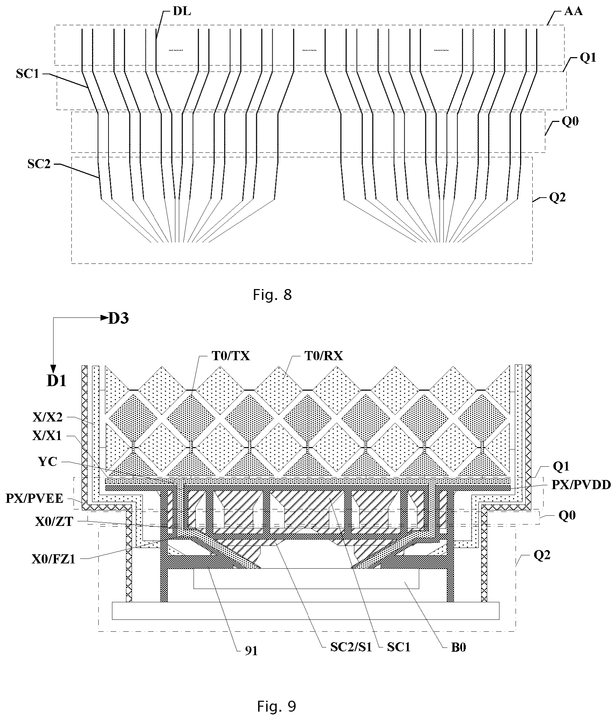

FIG. 3 illustrates the plurality of first fan-out lines SC1 and the plurality of second fan-out lines SC2 using similar shaded shapes, but in fact there are multiple independent signal lines in both the plurality of first fan-out lines SC1 and the plurality of second fan-out lines SC2, for example, reference may be made to FIG. 8, which is a wiring schematic diagram of a data line DL in a display panel provided by an embodiment of the present disclosure. The display region AA includes the data line DL, the trace region Q1 includes the first fan-out line SC1 electrically connected to the data line DL, and the function region Q2 includes the second fan-out line SC2 electrically connected to the first fan-out line SC1. Along the second direction, the first branch FZ1 does not overlap with the second fan-out line SC2.

In the present disclosure, when the touch control trace X0 is disposed in the function region Q2, the body portion ZT of the touch control trace X0 is located on one side of the first branch FZ1 facing the display region AA. In the embodiment shown in FIG. 3, the body portion ZT extends along the first direction D1, and a part of the first branch FZ1 connected to the body portion ZT extends along a third direction D3 and further extends to the position where the bonding pin B0 is located. It should be noted that both the body portion ZT and the first branch FZ1 include a plurality of touch-signal lines X.

Further referring to FIGS. 3 and 8, the data line DL in the display region AA is configured to provide a data signal to a pixel driving circuit corresponding to a light-emitting element. After being led out from the display region AA, the data line DL extends through the first fan-out line SC1 and the second fan-out line SC2 to the bonding pin B0 in the function region Q2, respectively. That is to say, the signal transmitted on the first fan-out line SC1 and the second fan-out line SC2 is also a data signal. In the function region Q2, the touch control trace X0 and the second fan-out line SC2 are arranged such that the first branch FZ1 of the touch control trace X0 is routed outside the second fan-out line SC2. In this way, the overlap between the first branch FZ1 and the second fan-out line SC2 can be avoided, which is beneficial to avoiding the data signal transmitted on the second fan-out line SC2 from affecting the touch control signal transmitted on the first branch FZ1, thereby improving the transmission accuracy of the touch control signal.

Further referring to FIG. 3, in an optional implementation of the present disclosure, along the second direction D2, the body portion ZT does not overlap with the second fan-out line SC2. In this embodiment, neither the body portion ZT nor the first branch FZ1 corresponding to the touch control trace X0 overlaps with the second fan-out line SC2, which is beneficial to avoiding the coupling influence of the data signal transmitted on the second fan-out line SC2 on the touch control signal transmitted on the body portion ZT and the first branch FZ1, and is more beneficial to improving the transmission accuracy of the touch control signal.

Further referring to FIG. 3, in an optional implementation of the present disclosure, in the function region Q2, both the body portions ZT and the first branches FZ1 are located at two sides of the second fan-out lines SC2 along a third direction D3, and the third direction D3 is not parallel to the first direction D1 and is perpendicular to the second direction. In this way, it is equivalent to that the body portion ZT and the first branch FZ1 of the touch control trace X0 are routed on either side of the second fan-out line SC2, avoiding that the body portion ZT and the first branch FZ1 are disposed in the region where the second fan-out line SC2 is located, which can avoid the signal coupling influence caused by the overlap of the body portion ZT and the first branch FZ1 of the touch control trace X0 with the second fan-out line SC2, and thus is beneficial to improving the transmission accuracy of the touch control signal. Optionally, referring to FIG. 3, the touch-signal line X further includes a lead-out portion YC connecting the touch-signal line X in the display region AA and the body portion ZT in the function region Q2. The lead-out portion YC is located in the trace region Q1, and along a transmission direction of the touch control signal, the lead-out portion YC is located between the body portion ZT and the touch electrode T0 in the display region AA. In this embodiment, two sides of the first fan-out line SC1 along the third direction D3 can be provided with the connection position of the body portion ZT and the lead-out portion YC, so as to avoid the overlap between the body portion ZT and the first fan-out line SC1.

FIG. 9 is another enlarged schematic diagram of the region A in FIG. 1. The difference between FIG. 9 and FIG. 3 is the connection position of the body portion ZT and the lead-out portion YC. Referring to FIG. 9, in an optional implementation of the present disclosure, along the second direction (which is perpendicular to the light-emitting surface of the display panel), the body portion ZT overlaps with the second fan-out line SC2, and the first signal line S1 includes the second fan-out line SC2, and the body portion ZT and the second fan-out line SC2 is isolated by the first shielding portion 91 in the region in which they overlap.

Compared with FIG. 3, the connection position of the body portion ZT and the lead-out portion YC in the embodiment in FIG. 9 is closer to the central position of the lower bezel of the display panel, while the connection position of the body portion ZT and the lead-out portion YC in FIG. 3 is closer to the edge position on either side of the lower bezel of the display panel. In practical applications, the connection position of the body portion ZT and the lead-out portion YC can be selected according to the actual situation. As shown in FIG. 9, when the connection position of the body portion ZT and the lead-out portion YC is closer to the central position of the lower bezel of the display panel, the body portion ZT will overlap with the second fan-out line SC2. In this case, the first shielding portion 91 can be provided in the region in which the body portion ZT and the second fan-out line SC2 overlap, and the first shielding portion 91 can be configured to signal-shield the body portion ZT and the second fan-out line SC2, thereby avoiding the problem of interference between the data signal on the second fan-out line SC2 and the touch control signal on the body portion ZT. When the body portion ZT overlaps with the second fan-out line SC2, the first branch FZ1 can also be routed peripherally to the second fan-out line SC2 by means of routing to avoid the overlap between the first branch FZ1 and the second fan-out line SC2, thereby reducing an area of the overlapping region between the touch control trace X0 and the second fan-out line SC2 and reducing the signal interference therebetween.

It should be noted that when the body portion ZT or the first branch FZ1 also overlaps other fan-out lines, the first shielding portion 91 may likewise be configured to shield the interference signals between the fan-out lines and the body portion ZT, which is likewise beneficial to improving the transmission accuracy of the touch control signal.

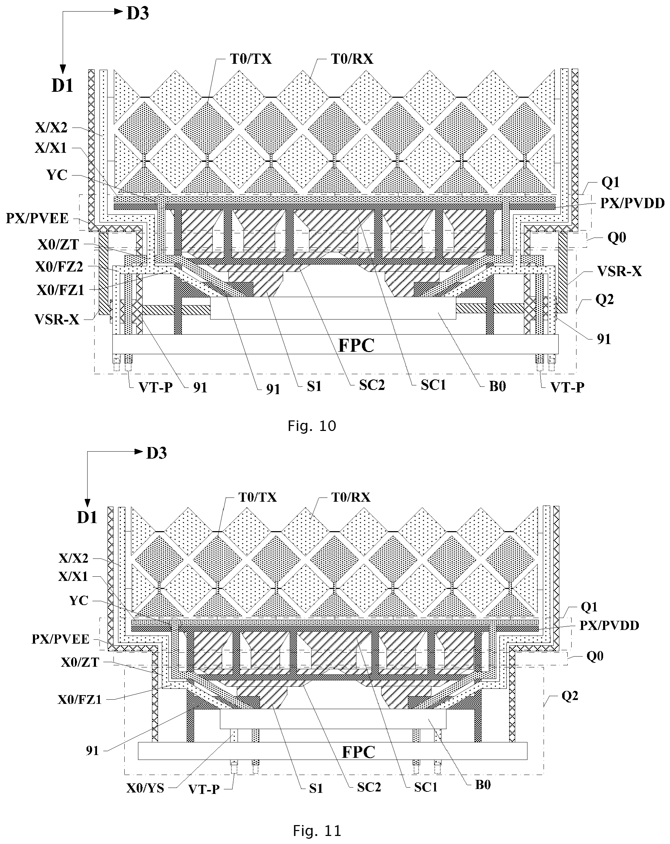

FIG. 10 is another enlarged schematic diagram of the region A in FIG. 1. Compared with FIG. 3, the difference is that the touch control trace X0 in the embodiment in FIG. 10 further includes a second branch FZ2. Referring to FIG. 10, in an optional implementation of the present disclosure, the display panel further includes a test pin VT-P located in the function region Q2, the touch control trace X0 further includes a second branch FZ2 located in the function region Q2, and both ends of the second branch FZ2 are electrically connected to the body portion ZT and the test pin VT-P respectively. Along the second direction D2, the second branch FZ2 does not overlap with the second fan-out line SC2.

This embodiment shows a solution in which the test pin VT-P provided in the function region Q2. During the manufacturing process of the display panel, various functions of the display panel can be tested by means of the test pin VT-P before assembling the finished product. In this embodiment, the touch control trace X0 in the function region Q2 is divided into two paths, namely the first branch FZ1 and the second branch FZ2. The first branch FZ1 is electrically connected to the bonding pin B0, and the second branch FZ2 is electrically connected to the test pin VT-P. When the second branch FZ2 of the touch control trace X0 is connected to the test pin VT-P, the touch control performance of the display panel can be tested by means of the test pin VT-P. Optionally, each of the lower left bezel and the lower right bezel of the function region Q2 is provided the test pin VT-P. In this way, when the second branch FZ2 is connected to the test pin VT-P, the overlap between the second branch FZ2 and the second fan-out line SC2 can be avoided, thereby avoiding the influence of the data signal transmitted on the second fan-out line SC2 on the touch control signal transmitted on the second branch FZ2, which is beneficial to improving the transmission accuracy of the touch control signal during the testing stage.

In the present disclosure, the power line PX is connected to the flexible circuit board FPC to obtain the power supply signal through the flexible circuit board FPC. Optionally, the test pin VT-P is located on one side of the flexible circuit board away from the bonding pin B0. When the second branch FZ2 is connected to the bonding pin B0, the second branch FZ2 can pass through the region where the flexible circuit board FPC is located and extend to the position where the test pin VT-P is located. Optionally, after the test is completed, the test pin VT-P can be removed according to the actual demand. Of course, the test pin VT-P can also be retained according to the demand, and the present disclosure does not specifically limit this.

Further referring to FIG. 10, in an optional implementation of the present disclosure, the non-step region A2 includes a gate driving circuit (not shown in the figure, the gate driving circuit is configured to provide a gate driving signal to a pixel circuit, for example, each of the left bezel and the right bezel of the display panel can be provided with gate driving circuit), the step region A1 includes a driving-signal fan-out line VSR-X electrically connected to the gate driving circuit, the first signal line S1 includes the aforementioned driving-signal fan-out line VSR-X. In the function region Q2, both sides of the second fan-out line SC2 along the third direction D3 are provided with the driving-signal fan-out line VSR-X, and the third direction D3 is not parallel to the first direction D1 and is perpendicular to the second direction. In the function region Q2, along the second direction D2, the driving-signal fan-out line VSR-X at least partially overlaps with the second branch FZ2, and the driving-signal fan-out line VSR-X and the second branch FZ2 are isolated by the first shielding portion 91 in the region in which they overlap. It should be noted that in the embodiments of the present disclosure, the positive power line PVDD and the negative power line PVEE are illustrated with different fillings, which do not represent their specific film layers. Since both the positive power line PVDD and the negative power line PVEE can be reused as the first shielding portion 91, in the schematic diagram, there may be a situation where different first shielding portions 91 correspond to different fillings.

When the display panel is provided with the gate driving circuit for providing the gate driving signal to the pixel driving circuit, the gate driving circuit is located in the non-step region, for example, the left and right bezel regions of the display panel are provided with the gate driving circuit. The gate driving circuit is electrically connected to the bonding pin B0 through the gate driving-signal fan-out line VSR-X in the step region. Since the left and right bezel regions of the display panel are provided with the gate driving circuit, in order to simplify the wirings, the positions near the edges on both sides of the step region, i.e., both sides of the second fan-out line SC2 along the third direction D3, can be provided with the gate driving-signal fan-out line connected to the gate driving circuit, to avoid the overlap between the gate driving-signal fan-out line and the second fan-out line SC2, which is beneficial to avoiding the signal crosstalk therebetween. When the second branch FZ2 in the touch control trace X0 is electrically connected to the test pin VT-P in the lower left region or the lower right region of the function region Q2, the second branch FZ2 is also located at the position in the function region Q2 close to the left edge or the right edge thereof. In this way, the driving-signal fan-out line VSR-X and the second branch FZ2 will overlap each other. In this case, the driving-signal fan-out line VSR-X is equivalent to the first signal line S1 in the present disclosure, the first shielding portion 91 can be provided between the driving-signal fan-out line VSR-X and the second branch FZ2, and the first shielding portion 91 is configured to shield the signals thereon, which is beneficial to avoiding the problem of signal crosstalk. It should be noted that the positive power line PVDD or the negative power line PVEE can be reused as the first shielding portion 91 here, and the present disclosure does not specifically limit this.

The embodiment shown in FIG. 10 shows a solution in which the touch control trace X0 is divided into two branches from the body portion ZT, namely the first branch FZ1 and the second branch FZ2, and the touch control trace X0 is electrically connected to the test pin VT-P through the second branch FZ2. In some other embodiments of the present disclosure, the connection between the touch control trace X0 and the test pin VT-P can also be achieved through other wiring methods. For example, referring to FIG. 11, which is another enlarged schematic diagram of the region A in FIG. 1, in an optional implementation of the present disclosure, the display panel further includes a test pin VT-P located in the function region Q2, and the test pin VT-P is located on one side of the bonding pin B0 away from the first branch FZ1; the touch control trace X0 further includes an extension portion YS located in the function region Q2, and both ends of the extension portion YS are electrically connected to the bonding pin B0 and the test pin VT-P.

The difference between the embodiments shown in FIG. 11 and FIG. 10 is the position of the test pin VT-P in the function region Q2 is different, and the connection manner between the touch control trace X0 and the test pin VT-P is different. In the embodiment shown in FIG. 10, the lower left region and the lower right region of the function region Q2 are provided with the test pin VT-P. In the embodiment shown in FIG. 11, the test pin VT-P is located at the position below the bonding pin B0 and near the center line of the function region Q2. During the manufacturing process of the display panel, the position of the test pin VT-P can be set according to the actual situation. Referring to FIG. 11, in this embodiment, the test pin VT-P is located directly below the bonding pin B0 as an example for illustration, in order to realize the test of the touch control function, the touch control trace X0 needs to be connected to the test pin VT-P. In this embodiment, the extension portion YS is provided. The extension portion YS is led out from the bonding pin B0 connected to the first branch FZ1 and directly extends to the position where the test pin VT-P is located without being led out from the body portion ZT. Such an arrangement simplifies the wiring complexity of the connection between the touch control trace X0 and the test pin VT-P, and at the same time reduces the wiring length, which is beneficial to simplifying the wiring process of the display panel while realizing the touch control detection.

Optionally, the test pin VT-P is located below the bonding pin B0 and on the one side of the flexible circuit board FPC away from the bonding pin B0. After being led out from the bonding pin B0, the extension portion YS passes through the region where the flexible circuit board FPC is located and then is electrically connected to the test pin VT-P. Optionally, after the test is completed, the test pin VT-P can be removed according to the actual demand. Of course, the test pin VT-P can also be retained according to the demand, and the present disclosure does not specifically limit this.

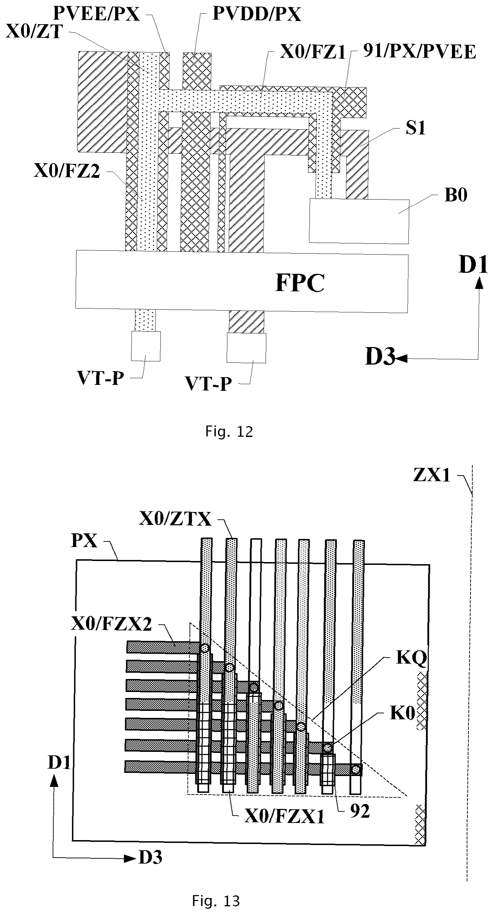

FIG. 12 is a relative positional relationship of a touch control trace X0, a first signal line S1 and a first shielding portion 91 in a function region Q2. Referring to FIG. 12, in an optional implementation of the present disclosure, the function region Q2 further includes a test pin VT-P. In the function region Q2, the touch control trace X0 includes a body portion ZT, a first branch FZ1, and a second branch FZ2. The body portion ZT is electrically connected to the touch-signal line in the trace region, both ends of the first branch FZ1 are electrically connected to the body portion ZT and the bonding pin B0, and both ends of the second branch FZ2 are electrically connected to the body portion ZT and the test pin VT-P. Along the second direction, the body portion ZT, the first branch FZ1, and the second branch FZ2 all overlap with the first shielding portion 91.

It should be noted that the embodiment in FIG. 12 merely is a relative positional relationship of the touch control trace X0, the first shielding portion 91, and the first signal line S1 in the function region Q2, and does not show other signal lines in the function region Q2. In addition, although the touch control trace X0 in this embodiment is illustrated as a whole with a unified filling, in fact, the touch control trace X0 includes a plurality of independent signal lines. Similarly, although the first signal line S1 in this embodiment is illustrated with a unified filling, in fact, the first signal line S1 includes a plurality of independent signal lines. The first signal line S1 can be, for example, the fan-out line corresponding to the data line DL, or other signal lines for transmitting alternating current signals. Two branches, namely the first branch FZ1 and the second branch FZ2, are led out from the body portion ZT corresponding to the touch control trace X0. The first branch FZ1 is used for electrically connecting to the bonding pin B0, and the second branch FZ2 is used for electrically connecting to the test pin VT-P. Optionally, the bonding region where the bonding pin B0 corresponding to the first branch FZ1 is located is used for electrically connecting to a driving chip, the test pin VT-P is located below the flexible circuit board FPC, the second branch FZ2 passes through the region where the flexible circuit board is located and then is electrically connected to the test pin VT-P, and the power line PX is electrically connected to the flexible circuit board and obtains the power supply voltage signal through the flexible circuit board. Optionally, a part signal line of the first signal line S1 also passes through the region where the flexible circuit board is located and is electrically connected to the test pin VT-P to realize the test function.

This embodiment shows a situation where both the first branch FZ1 and the second branch FZ2 of the touch control trace X0 overlap with the first signal line S1. In this case, along the second direction D2, the body portion ZT, the first branch FZ1, and the second branch FZ2 all overlap with the first shielding portion 91. In particular, the first shielding portion 91 is provided in the overlapping region between the first branch FZ1 and the first signal line S1 as well as the overlapping region between the second branch FZ2 and the first signal line S1 for shielding the signal interference of the first signal line S1 on the touch control trace X0. It should be noted that at least one of the positive power line PVDD and the negative power line PVEE in the display panel can be reused as the first shielding portion 91. This embodiment shows a solution in which the first shielding portion 91 overlapping the body portion ZT and the second branch FZ2 includes the negative power line PVEE, and the first shielding portion 91 overlapping the first branch FZ1 includes both the positive power line PVDD and the negative power line PVEE, but the present disclosure is not limited thereto. If the regions where the positive power line PVDD and the negative power line PVEE are located do not include the above-mentioned overlapping regions in the actual manufacturing process, the positive power line PVDD or the negative power line PVEE can be extended into the aforementioned overlapping regions to play the function of signal-shielding. In this way, there is no need to provide another structure as the first shielding portion 91 in the display panel, which is beneficial to simplifying the overall structure and manufacturing process of the display panel.

FIG. 13 is a wiring schematic diagram of a body portion ZT, a first branch FZ1, and a second branch FZ2 of a touch control trace X0 of a function region Q2 in FIG. 9, FIG. 10, or FIG. 11, which can be regarded as the refinement of the body portion and the branches located in the left region of the function region Q2 in FIG. 9, FIG. 10, or FIG. 11. The refinement of the body portion and the branches located in the right region of the function region Q2 can be regarded as a structure arranged symmetrically with FIG. 13 and will not be described further in this disclosure. In conjunction with FIG. 10 and FIG. 13, in an optional implementation of the present disclosure, the function region Q2 includes the bonding pin B0 and a test pin VT-P; the touch control trace X0 includes a trunk line ZTX, a first branch line FZX1, and a second branch line FZX2. The trunk line ZTX is electrically connected to the touch-signal line X in the trace region, the first branch line FZX1 is electrically connected between the trunk line ZTX and the bonding pin B0 respectively, and the second branch line FZX2 is electrically connected between the trunk line ZTX and the test pin VT-P. The first branch line FZX1 and the trunk line ZTX are disposed in a same layer, the second branch line FZX2 and the trunk line ZTX are disposed in different layers and are electrically connected to each other through a first via K0, and the first branch line FZX1 and the second branch line FZX2 extends along different directions. In this embodiment, the first branch line FZX1 extends in the first direction and the second branch line FZX2 extends in the second direction an example for illustration.

This embodiment illustrates the refined wiring structure of the touch control trace X0, where the entirety formed by a plurality of trunk lines ZTX can be regarded as the body portion ZT in the above-mentioned embodiments, the entirety formed by a plurality of first branch lines FZX1 can be regarded as the signal line arrangement in a partial region of the first branch FZ1 in the above-mentioned embodiments, and the entirety formed by a plurality of second branch lines FZX2 can be regarded as the signal line arrangement in a partial region of the second branch FZ2 in the above-mentioned embodiments. Along the first direction D1, an end of the trunk line ZTX away from the display region AA includes a branch point (the position where the first via K0 is located). Two branch lines are led out from this branch point, namely the first branch line FZX1 and the second branch line FZX2. The first branch line FZX1 and the second branch line FZX2 extend along different directions. The trunk line ZTX and the first branch line FZX1 are disposed in a same layer and can be manufactured in a same process, and the second branch line FZX2 and the trunk line ZTX are located in different film layers. At the position where the branch point is located, the second branch line FZX2 is electrically connected to the trunk line ZTX through the first via K0, so that the first branch line FZX1 and the second branch line FZX2 respectively extend towards the corresponding pins in different film layers, that is, the first branch line FZX1 extends towards the region where the bonding pin B0 is located, and the second branch line FZX2 extends towards the region where the test pin VT-P is located. The way of disposing the first branch line FZX1 and the second branch line FZX2 in different layers is beneficial to simplifying the wiring difficulty of the touch control trace X0 in the function region Q2 and improving the production efficiency of the display panel.

Further referring to FIG. 13 and in conjunction with FIG. 10, in an optional implementation of the present disclosure, the trunk lines ZTX and the first branch lines FZX1 respectively extend along the first direction D1 and are arranged along the third direction D3, the second branch lines FZX2 are arranged along the first direction D1 and extend along the third direction D3, and the first direction D1 is not parallel to the third direction D3. The function region Q2 has a first center line ZX1 extending along the first direction D1. On a same side of the first center line ZX1, along a direction parallel to the third direction D3 and pointing from the first center line ZX1 to an edge of the display panel, lengths of the trunk lines ZTX gradually decrease, lengths of the first branch lines FZX1 gradually increase, and each first via is located between the respective trunk line ZTX and the respective first branch line FZX1 that are connected.

This embodiment shows a solution in which the lengths of the trunk lines ZTX are set in the form of gradual change. Specifically, the trunk lines ZTX in the left region of the function region Q2 are taken as an example for illustration, the arrangement of the trunk lines ZTX in the right region of the function region Q2 is distributed symmetrically with the arrangement of the trunk lines ZTX in the left region. Along the direction from the first center line of the function region Q2 towards the left edge of the function region Q2, the lengths of the trunk lines ZTX gradually decrease, that is, the closer to the first center line ZX1 of the function region Q2, the greater the length of the trunk line ZTX, and the branch point on the trunk line ZTX (corresponding to the position where the first via K0 is located) is closer to the lower edge of the function region Q2. Correspondingly, the length change trend of the corresponding first branch lines FZX1 is opposite to the length change trend of the trunk lines ZTX. In this way, when the second branch lines FZX2 are led out from the branch points on all of the trunk lines ZTX along the third direction D3, an insulating space can be provided between two adjacent second branch lines FZX2, so that all of the second branch lines FZX2 can be provided in a same film layer, and there is no need to provide different film layers for different second branch lines FZX2. Therefore, it is beneficial to simplifying the overall film layer structure of the function region Q2 in the display panel and reducing the wiring difficulty of the trunk lines and the branch lines in the touch control trace X0.

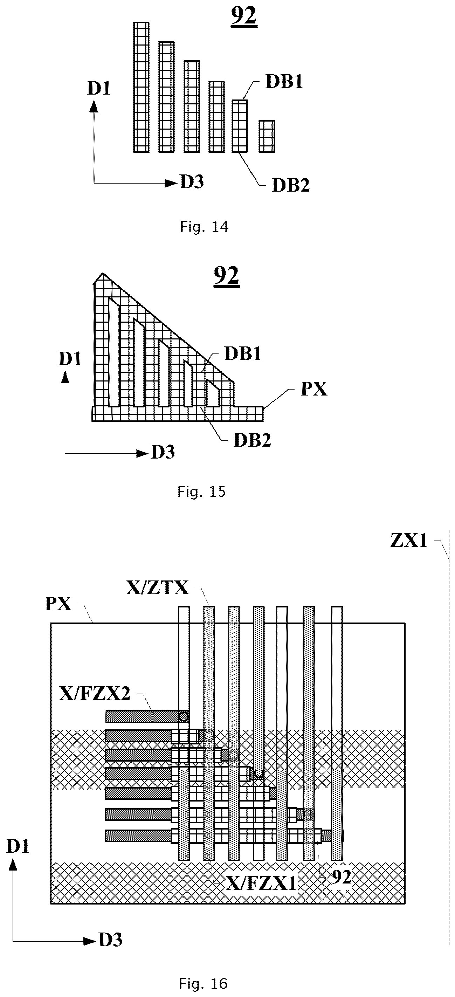

FIG. 14 is a top view of second shielding portions 92 provided between first branch lines FZX1 and second branch lines FZX2. Further referring to FIG. 13 and in conjunction with FIG. 14, in an optional implementation of the present disclosure, along the second direction, the first branch lines FZX1 overlap the second branch lines FZX2. The display panel further includes second shielding portions 92 located between the first branch lines FZX1 and the second branch lines FZX2, and the second shielding portions 92 are configured to receive a fixed potential.

When the wiring structure shown in FIG. 13 is used to arrange the trunk line ZTX, the first branch line FZX1, and the second branch line FZX2, the first branch line FZX1 and the second branch line FZX2 are wired in different film layers, and there will be an overlapping region therebetween. When the first branch line FZX1 and the second branch line FZX2 that overlap are of different touch control traces X0, different touch control signals transmitted by the two may cause the problem of signal crosstalk and affect the touch control accuracy. Therefore, in the present disclosure, the second shielding portions 92 are provided between the first branch line FZX1 and the second branch line FZX2. Since the second shielding portions 92 receive a fixed potential, it can shield the signals on the first branch line FZX1 and the second branch line FZX2, which is beneficial to avoiding the problem of signal crosstalk and thus beneficial to improving the touch control accuracy.

It should be noted that in the actual manufacturing process of the second shielding portions 92, the second shielding portions 92 can be provided only in the overlapping region of the first branch line FZX1 and the second branch line FZX2, or the area of the second shielding portions 92 can be expanded on this basis. For example, further referring to FIG. 13 and FIG. 14, in an optional implementation of the present disclosure, the second shielding portions 92 extend along the first direction D1 and are arranged along the third direction D3. Along the second direction D2, the second shielding portions 92 and the second branch lines FZX2 overlap each other and are disposed in a one-to-one correspondence.

The second shielding portions 92 shown in FIG. 14, in addition to covering the overlapping region of the first branch line FZX1 and the second branch line FZX2, further undergoes an area enlargement. Specifically, the top view structure of the second shielding portion 92 corresponds to the top view structure of the first branch line FZX1. Optionally, along the second direction, a projection of the second shielding portion 92 coincides with a projection of the first branch line FZX1, or a projection of the first branch line FZX1 is within the range of a projection of the second shielding portion 92. Adopting the same structure as the wiring structure of the first branch line FZX1 to provide the second shielding portion 92 can simplify the structure of the second shielding portion 92. In the overlapping regions corresponding to the first branch lines FZX1 and the second branch lines FZX2, the overlapping regions in a same column along the first direction D1 correspond to a same second shielding portion 92. In this way, there is no need to provide different second shielding portions 92 for different overlapping regions, which is beneficial to reducing the number of second shielding portions 92 actually corresponding to the first branch lines FZX1 and the second branch lines FZX2, and is also beneficial to simplifying the manufacturing process of the second shielding portions 92 while ensuring that all of the overlapping regions of the first branch lines FZX1 and the second branch lines FZX2 are shielded by the corresponding second shielding portions 92.

FIG. 15 is another top view of second shielding portions 92 provided between first branch lines FZX1 and second branch lines FZX2. In conjunction with FIG. 14 and FIG. 15, in an optional implementation of the present disclosure, each of the second shielding portions 92 includes a first end DB1 and a second end DB2 opposite to each other along the first direction D1, first ends DB1 of all the second shielding portions 92 are electrically connected to each other, and second ends DB2 of all the second shielding portions 92 are electrically connected to each other.

Compared with the embodiment shown in FIG. 14, referring to FIG. 15, in this embodiment, the ends of all the second shielding portions 92 are electrically connected. For example, the first ends DB1 of all the second shielding portions 92 are electrically connected to each other, and the second ends DB2 of all the second shielding portions 92 are electrically connected to each other. In this way, all the second shielding portions 92 form an integral structure and have an equal potential. When transmitting a fixed potential to the second shielding portions 92, only one signal interface needs to be led out from the second shielding portions 92 as a whole, and there is no need to provide different signal interfaces for different second shielding portions 92. Therefore, this is beneficial to simplifying the connection between the second shielding portions 92 and the fixed potential and the wiring structure of the function region Q2.

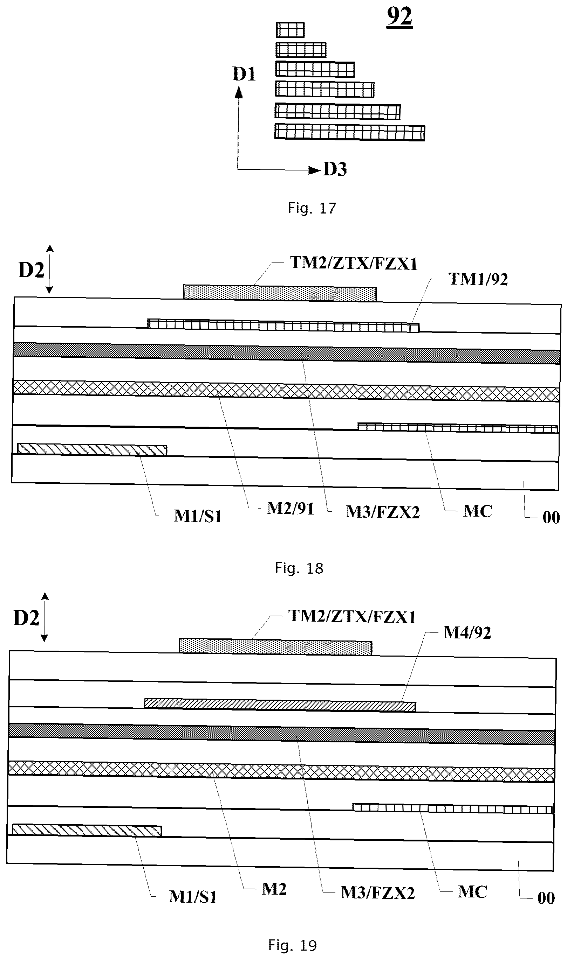

It should be noted that FIG. 14 and FIG. 15 show the solutions in which the second shielding portion 92 is provided with the same structure as the first branch line FZX1. In some other embodiments of the present disclosure, the second shielding portion 92 can also be provided with the same structure as the second branch line FZX2. For example, referring to FIG. 16 and FIG. 17, where FIG. 16 is another wiring schematic diagram of a body portion ZT, a first branch FZ1, and a second branch FZ2 of a touch control trace X0 in a function region Q2, and FIG. 17 is another top view of second shielding portions 92 disposed between first branch lines FZX1 and second branch lines FZX2, the second shielding portions 92 extend along the third direction D3 and are arranged along the first direction D1, and the length change trend of the second shielding portions 92 is the same as the length change trend of the second branch lines FZX2. Optionally, along the second direction D2, a projection of the second shielding portion 92 coincides with a projection of the second branch line FZX2, or a projection of the second branch line FZX2 is within the range of a projection of the second shielding portion 92. In this case, in the multiple overlapping regions of the first branch lines FZX1 and the second branch lines, the overlapping regions in a same row along the third direction D3 correspond to a same second shielding portion 92, and there is no need to provide different second shielding portions 92 for different overlapping regions, which is also beneficial to reducing the number of the second shielding portions 92 and simplifying the manufacturing process of the display panel. Optionally, ends of the second shielding portions 92 along the third direction D3 are electrically connected to each other. In this way, the second shielding portions 92 can also form an integral structure with an equal potential, and the transmission of a fixed potential to the second shielding portions 92 can be realized by providing only one signal interface, which is also beneficial to simplifying the connection between the second shielding portions 92 and the fixed potential.

Appropriately referring to FIG. 13 and FIG. 15, in an optional implementation of the present disclosure, the display panel further includes a power line PX. The power line PX is configured to provide a direct-current power supply to the display region AA, and the second shielding portions 92 are electrically connected to the power line PX.

In conjunction with FIG. 10, the power line PX mentioned in the present disclosure can be a positive power line PVDD or a negative power line PVEE. In the actual manufacturing process, the second shielding portions 92 can be electrically connected to the positive power line PVDD or the negative power line PVEE. A direct-current power supply is provided through the positive power line PVDD or the negative power line PVEE to the second shielding portions 92 as the fixed potential on the second shielding portions 92. There is no need to provide a new fixed potential for the second shielding portions 92, which is beneficial to simplifying the number of signal terminals in the display panel and the structure of the display panel.

FIG. 18 is a schematic diagram of film layers in a function region Q2 of a display panel provided by the present disclosure. Referring to FIG. 18, in an optional implementation of the present disclosure, the display panel includes a substrate 00 and a plurality of metal layers disposed on one side of the substrate 00, and every pair of the metal layers adjacent along the second direction D2 are isolated by an insulating layer. The metal layers include a first metal layer M1, a second metal layer M2, a third metal layer M3, a first touch control metal layer TM1, and a second touch control metal layer TM2, which are arranged in the above-listed sequence along a direction from the substrate to the light-emitting surface of the display panel. In the function region Q2, in conjunction with FIGS. 10 and 13 to 17, the trunk lines ZTX and the first branch lines FZX1 are located in the second touch control metal layer TM2, the second branch lines FZX2 are located in the third metal layer M3, the second shielding portions 92 are located in the first touch control metal layer TM1, the first shielding portion 91 is located in the second metal layer M2, and the first signal line S1 is located on one side of the first shielding portion 91 facing the substrate.

It should be noted that the embodiment shown in FIG. 18 merely illustrates the relative position relationship of the first metal layer M1, the second metal layer M2, the third metal layer M3, the first touch control metal layer TM1, and the second touch control metal layer TM2 in the function region Q2, and does not represent the actual number of the film layers in the function region Q2. In some other embodiments of the present disclosure, other conductive film layers may be included between two adjacent metal layers. For example, a capacitive metal layer MC may exist between the first metal layer M1 and the second metal layer M2, and the present disclosure does not specifically limit this. In this embodiment, along the direction from the substrate 00 to the metal layers on a same side, the first metal layer M1, the second metal layer M2, the third metal layer M3, the first touch control metal layer TM1, and the second touch control metal layer TM2 are sequentially stacked, and the first metal layer M1 is closest to the substrate, and the second touch control metal layer TM2 is farthest from the substrate.

In the display region AA, in conjunction with FIG. 5, the driving layer 40 includes a plurality of transistors M0. Gates of the transistors are usually disposed in the aforementioned first metal layer M1, and sources s and drains d of the transistors are usually disposed in the aforementioned second metal layer M2. The third metal layer M3 can be used, for example, to dispose the power line PX, and the first touch control metal layer TM1 and the second touch control metal layer TM2 are used to dispose bridging lines between the touch electrodes T0. Referring to FIG. 18, in the trace region corresponding to the function region Q2, no transistor is disposed, and thus these metal layers can be used for wiring. In this embodiment, in the function region Q2, the trunk line ZTX and the first branch line FZX1 are located in the second touch control metal layer TM2, and the second branch line FZX2 is located in the third metal layer M3. The trunk line ZTX and the second branch line FZX2 are electrically connected to each other through a connection hole running through the insulating layer between the second touch control metal layer TM2 and the third metal layer M3. In this case, no touch control trace X0 is disposed in the first touch control metal layer TM1, and the second shielding portions 92 can be disposed in the first touch control metal layer TM1, so that the second shielding portions 92 are located between the film layers where the first branch line FZX1 and the second branch line FZX2 are located, to achieve signal-shielding between the first branch line FZX1 and the second branch line FZX2 that overlap, avoiding the problem of signal crosstalk between the first branch line FZX1 and the second branch line FZX2. Optionally, in the function region Q2, the second metal layer M2 and the third metal layer M3 are used to dispose the power line PX. It should be noted that in this embodiment, when the second branch line FZX2 is disposed in the third metal layer M3, the power line PX is no longer disposed in the region where the second branch line FZX2 is disposed in the third metal layer M3. In this embodiment, when the second shielding portions 92 are disposed in the first touch control metal layer TM1, the second shielding portions 92 can be connected to the power line PX reserved on the third metal layer M3 through a via hole, and thus there is no need to provide a new fixed potential, which is beneficial to simplifying the structural design of the display panel.

For the first signal line S1 in the function region Q2, wiring may be carried out in the first metal layer M1, and of course, wiring may also be carried out simultaneously in the capacitive metal layer MC between the first metal layer M1 and the second metal layer M2. That is to say, the first signal line S1 is located on one side of the second metal layer M2 facing the substrate. In this case, the first shielding portion 91 can be disposed in the second metal layer M2, which is equivalent to disposing the first shielding portion 91 between the film layers where the touch control trace X0 and the first signal line S1 are located, so that the first shielding portion 91 can play a good signal shielding effect and avoid the influence of the alternating current signal on the first signal line S1 on the signal on the touch control trace X0. Optionally, in the function region Q2, the second metal layer M2 and the third metal layer M3 are used to dispose the power line PX. In this case, the power line PX in the second metal layer M2 can be reused as the first shielding portion 91, and thus there is no need to provide a new film layer to dispose the first shielding portion 91, which is beneficial to simplifying the film layer structure of the display panel.

FIG. 19 is another schematic diagram of film layers in a function region Q2 of a display panel provided by the present disclosure. Referring to FIG. 19, in an optional implementation of the present disclosure, the display panel includes a substrate 00 and a plurality of metal layers disposed on one side of the substrate 00, and every pair of the metal layers adjacent along the second direction D2 are isolated by an insulating layer. The metal layers include a first metal layer M1, a second metal layer M2, a third metal layer M3, a fourth metal layer M4, a first touch control metal layer TM1, and a second touch control metal layer TM2, which are arranged in the above-listed sequence along a direction from the substrate to the light-emitting surface of the display panel,. In the function region Q2, the trunk lines ZTX and the first branch lines FZX1 are located in the second touch control metal layer TM2, the second branch lines FZX2 are located in the third metal layer M3, the second shielding portions 92 are located in the fourth metal layer M4, the first shielding portion 91 is located in the second metal layer M2, and the first signal line S1 is located on one side of the first shielding portion 91 facing the substrate.

The difference between the embodiments shown in FIG. 19 and FIG. 18 is that the fourth metal layer M4 is provided between the first touch control metal layer TM1 and the third metal layer M3, and the other similarities are not be repeated. Optionally, the fourth metal layer M4 is used to dispose the power line PX. In conjunction with FIGS. 10, 13 and 19, in this embodiment, the trunk line ZTX and the first branch line FZX1 are likewise located in the second touch control metal layer TM2, and the second branch line FZX2 is located in the third metal layer M3. In this way, two metal film layers, namely the fourth metal layer M4 and the first touch control metal layer TM1, will be included between the film layers where the first branch line FZX1 and the second branch line FZX2 are located. In this case, the second shielding portions 92 can be disposed in the fourth metal layer M4, and the power line PX in the fourth metal layer M4 is used as the second shielding portions 92, and thus there is no need to provide a new film layer and signal for the second shielding portions 92 in the display panel, which is beneficial to simplifying the design of the display panel.

In this embodiment, for the first signal line S1 in the function region Q2, wiring may be carried out in the first metal layer M1, and of course, wiring may also be carried out simultaneously in the capacitive metal layer MC between the first metal layer M1 and the second metal layer M2. That is to say, the first signal line S1 is located on one side of the second metal layer M2 facing the substrate. In this case, the first shielding portion 91 can be disposed in the second metal layer M2, which is equivalent to disposing the first shielding portion 91 between the film layers where the touch control trace X0 and the first signal line S1 are located, so that the first shielding portion 91 can play a good signal shielding effect, avoiding the influence of the alternating current signal on the first signal line S1 on the signal on the touch control trace X0. Optionally, in the function region Q2, the power line PX can be distributed in the second metal layer M2, the third metal layer M3, and the fourth metal layer M4, which is beneficial to reducing the voltage drop on the power line PX. In this case, the power line PX in the second metal layer M2 can be directly reused as the first shielding portion 91, and thus there is no need to provide a new film layer to dispose the first shielding portion 91, which is beneficial to simplifying the film layer structure of the display panel.

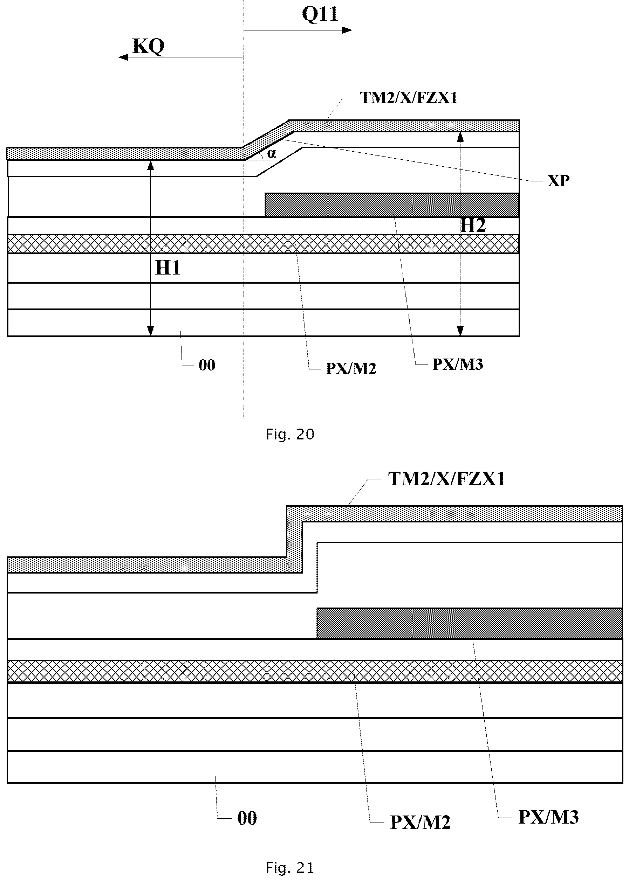

FIG. 20 is a wiring schematic diagram of a first branch line FZX1 at a junction between a jumper-wire region KQ and a first region Q11, and FIG. 21 is a comparative schematic diagram corresponding to FIG. 20. In the embodiment shown in FIG. 20, a slope XP is formed at the junction between the jumper-wire region KQ and the first region Q11. In the embodiment shown in FIG. 21, no slope XP is formed at the junction between the jumper-wire region KQ and the first region Q11. Referring to FIGS. 20, 21, 10, and 13, in an optional implementation of the present disclosure, the display panel includes a substrate 00 and a plurality of metal layers disposed on one side of the substrate 00, and every pair of the metal layers adjacent along the second direction D2 are isolated by an insulating layer. The metal layers include a first metal layer M1, a second metal layer M2, a third metal layer M3, a first touch control metal layer TM1, and a second touch control metal layer TM2, which are arranged in the above listed sequence along a direction from the substrate to the light-emitting surface of the display panel. The first branch lines FZX1 are located in the second touch control metal layer TM2. The function region Q2 includes a jumper-wire region, and the first branch lines FZX1 and the second branch lines FZX2 overlap each other in the jumper-wire region KQ. In the jumper-wire region KQ, a distance between the insulating layer at a surface of the first branch lines FZX1 facing the substrate and the substrate is H1. The function region Q2 includes a first region Q11 adjacent to the jumper-wire region. In the first region Q11, a distance between the insulating layer on at a surface of the first branch lines FZX1 facing the substrate and the substrate is H2, where H1<H2. At a junction between the jumper-wire region and the first region, the insulating layer on the surface of the first branch lines FZX1 facing the substrate has a slope XP, and the slop rises along a direction from the jumper-wire region to the first region. The first branch lines FZX1 extend into the first region Q11 through the slope XP.

In the present disclosure, in the function region Q2, at least two film layers may be provided with the power line PX arranged in a planar shape. For example, at least the second metal layer M2 and the third metal layer M3 are provided with the power line PX, and the power lines PX located in the two metal layers and transmitting the same power supply signal are electrically connected to each other, which is beneficial to reducing the overall impedance of the power lines PX and the voltage drop of the power supply signal transmitted by the power lines PX. When the second branch line FZX2 is disposed in the film layer where the power line PX would otherwise be located, for example, when the second branch line FZX2 is disposed in the jumper-wire region of the third metal layer M3, the planar power line PX is no longer disposed in the jumper-wire region of the third metal layer M3, but is replaced with the strip-shaped second branch line FZX2. When an insulating layer is provided on one side of the third metal layer M3 facing away from the substrate, in the jumper-wire region, the insulating layer is filled at least between the strip-shaped second branch lines FZX2, while the insulating layer in other regions (the first region, which can be regarded as other regions in the function region Q2 adjacent to the jumper-wire region) is disposed above the full-plane power line PX, which makes the overall thickness of the insulating layer in the jumper-wire region smaller than the thickness of the insulating layer in other regions. For example, referring to FIG. 20, there is a height difference across the junction between the jumper-wire region KQ and the first region Q11. Since the film layer where the first branch line FZX1 is located is above the insulating layer, when the first branch line FZX1 passes through the jumper-wire region and further extends towards the first region, the position of the height step may cause the first branch line FZX1 to break. To this end, referring to FIG. 20, in the present disclosure, the slope XP is provided at the position of the height step, and the height of the ramp gradually increases along the direction from the jumper-wire region to the first region, which can achieve a smooth transition of the first branch line FZX1 from the jumper-wire region to the first region and effectively avoid the problem of wire breakage.

Further referring to FIG. 20, in an optional implementation of the present disclosure, an included angle between an inclined surface and a bottom surface of the slope XP is $\alpha$, where $\alpha \leq 50°$. It should be noted that the smaller the included angle between the inclined surface and the bottom surface of the slope XP, the gentler the ramp is, and the more the problem of wire breakage of the first branch line FZX1 can be avoided. In the present disclosure, setting the included angle between the inclined surface and the bottom surface of the slope XP to be less than or equal to 50° is more conducive to the smooth transition of the first branch line FZX1 to the first region, and is beneficial to improving the reliable coverage of the first branch line FZX1 at the junction between the jumper-wire region and the first region, avoiding the problem of wire breakage.

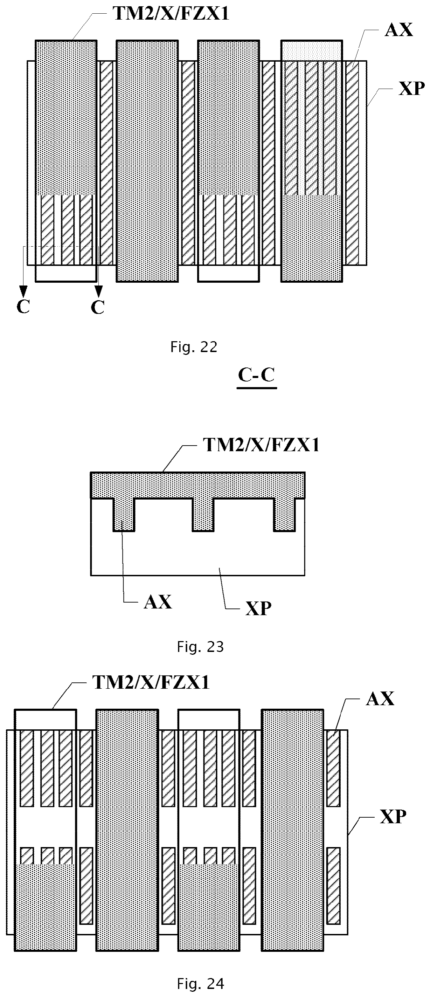

When forming the slope XP at the junction between the jumper-wire region and the first region, an upper surface of the inclined surface of the slope XP can be of a flat structure. In some other embodiments of the present disclosure, the upper surface of the inclined surface of the slope XP can also be of a non-flat structure. For example, referring to FIG. 22 and FIG. 23, where FIG. 22 is a top view of a slope XP and a first branch line FZX1, and FIG. 23 is a cross-sectional view along a direction CC corresponding to a structure in FIG. 22, in an optional implementation of the present disclosure, the inclined surface of the slope XP includes a plurality of trenches AX extending from a bottom of the slope to a top of the slope. Along the second direction, the first branch lines FZX1 overlaps the trenches AX. Along the third direction D3, a dimension of the first branch line FZX1 is greater than a dimension of the trench AX.

Further referring to FIG. 22 and FIG. 23, in this embodiment, the trenches AX are provided on the inclined surface of the slope XP, the trenches AX can be regarded as structures recessed from the inclined surface to the bottom surface. The trenches AX are strip-shaped structures extending from the top to the bottom of the slope XP, and a width of the trench AX is smaller than a line width of the first branch line FZX1. When the first branch line FZX1 extends on the slope XP, the first branch line FZX1 covers at least two trenches AX, and at least part of the first branch line FZX1 is filled in the trenches AX. In this way, it is more beneficial to improving the coverage of the first branch line FZX1 on the slope XP, and more conducive to avoiding the problem of wire breakage of the first branch line FZX1.

FIG. 22 shows a solution in which a row of trenches AX are formed on the slope XP, and the trenches AX extend from the top of the slope to the bottom of the slope. In some other embodiments of the present disclosure, two or more rows of trenches AX may be formed on the slope, for example, referring to FIG. 24, which is another top view of a slope XP and a first branch line FZX1. Compared with the embodiment shown in FIG. 22, the length of the trench AX in FIG. 24 is shorter, but the overall extension direction of the trenches AX is the same as the extension direction of the trenches AX in FIG. 20. When the first branch line FZX1 is formed on the inclined surface of the slope XP, the first branch line FZX1 can likewise be filled into the trenches AX to improve the coverage of the first branch line FZX1 on the inclined surface.

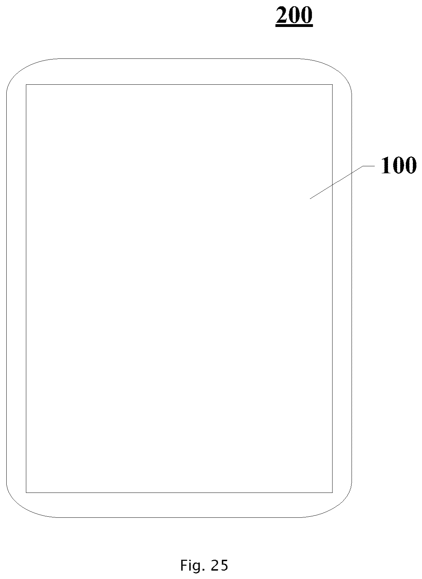

Based on the same inventive concept, the present disclosure further provides a display apparatus. FIG. 25 is a structural schematic diagram of a display apparatus 200 provided by an embodiment of the present disclosure. Referring to FIG. 25, the display apparatus 200 includes the display panel 100 in any of the above embodiments. The display apparatus 200 provided by the embodiment of the present disclosure can be any electronic device with a display function, such as a touch display screen, a mobile phone, a tablet computer, a notebook computer, an electronic paper book, or a television. The display apparatus 200 provided by the embodiment of the present disclosure has the beneficial effects of the display panel provided by the embodiments of the present disclosure. For details, reference can be made to the specific descriptions of the display panel in the above embodiments, which will not be repeated here.

It can be understood FIG. 25 merely illustrates one shape of the display apparatus 200 by taking a rounded rectangular structure as an example. In some other embodiments of the present disclosure, the display apparatus 200 can also be embodied in a circle, an ellipse, or any other feasible shape, and the present disclosure does not specifically limit this.

It should be noted that in this document, relational terms such as "first" and "second" are only used to distinguish one entity or operation from another entity or operation, and do not necessarily require or imply any actual relationship or order between these entities or operations. Moreover, the terms "include", "comprise" or any other variants thereof are intended to cover a non-exclusive inclusion, so that a process, method, article, or device including a series of elements not only includes those elements, but also includes other elements not explicitly listed, or elements inherent to the process, method, article, or device. Without more limitations, an element defined by the sentence "include one..." does not exclude the existence of other identical elements in the process, method, article or device including the element.

The above are only the specific implementations of the present disclosure, enabling those of skill in the art to understand or implement the present disclosure. Various modifications to these embodiments will be apparent to those of skill in the art, and the general principles defined in this document can be implemented in other embodiments without departing from the spirit or scope of the present disclosure. Therefore, the present disclosure should not be limited to these embodiments described herein, but should conform to the broadest scope consistent with the principles and novel features disclosed herein.

**Claims**

1. A display panel, comprising:

    a display region and a non-display region disposed outside the display region, wherein the non-display region comprises a step region and a non-step region, the step region comprises a trace region and a function region that are arranged along a first direction, and a bonding pin is located in the function region;
    a touch electrode and a touch-signal line electrically connected to the touch electrode, wherein the touch-signal line extends from the trace region to the function region and is electrically connected to the bonding pin; and
    a first signal line located in the function region, wherein the first signal line is configured to transmit an alternating current signal;
    wherein along a second direction, the first signal line at least partially overlaps with a touch control trace, the touch control trace is a part of the touch-signal line located in the function region, the first signal line and the touch control trace are isolated by a first shielding portion in a region in which the first signal line and the touch control trace overlap, the first shielding portion is configured to receive a fixed potential, and the second direction is perpendicular to a light-emitting surface of the display panel.

2. The display panel according to claim 1, further comprising:

    a power line, configured to provide a direct-current power supply to the display region, wherein in the function region, the power line is reused as the first shielding portion.

3. The display panel according to claim 2, further comprising:

    a substrate, wherein the power line and the first signal line are located on a same side of the substrate; and
    an organic insulating layer, wherein the organic insulating layer is in contact with the power line and is located on a side of the power line facing the substrate;
    wherein a plurality of through holes are provided in the power line, the plurality of through holes extends along the second direction and runs through the power line, and the plurality of through holes does not overlap with the first signal line along the second direction.

4. The display panel according to claim 1, wherein:

    in the function region, the touch control trace comprises a body portion and a first branch, the body portion is electrically connected to the touch-signal line, and two ends of the first branch are electrically connected to the body portion and the bonding pin, respectively; and
    a data line is located in the display region, a first fan-out line electrically connected to the data line is located in the trace region, a second fan-out line electrically connected to the first fan-out line is located in the function region, and the first branch does not overlap with the second fan-out line along the second direction.

5. The display panel according to claim 4, wherein the body portion does not overlap with the second fan-out line along the second direction.

6. The display panel according to claim 5, wherein in the function region, the body portion is located at two sides of the second fan-out line along a third direction, the first branch is located at the two sides of the second fan-out line along the third direction, and the third direction is not parallel to the first direction and is perpendicular to the second direction.

7. The display panel according to claim 4, wherein the body portion overlaps with the second fan-out line along the second direction, the first signal line comprises the second fan-out line, and the body portion and the second fan-out line are isolated by the first shielding portion in a region in which the body portion and the second fan-out line overlap along the second direction.

8. The display panel according to claim 4, further comprising:

   a test pin located in the function region;
   wherein the touch control trace further comprises a second branch located in the function region, two ends of the second branch are electrically connected to the body portion and the test pin, respectively, and the second branch does not overlap with the second fan-out line along the second direction.

9. The display panel according to claim 8, wherein:

   the non-step region comprises a gate driving circuit, the step region comprises a driving-signal fan-out line electrically connected to the gate driving circuit, and the first signal line comprises the driving-signal fan-out line;
   in the function region, the driving-signal fan-out line is located at two sides of the second fan-out line along a third direction, and the third direction is not parallel to the first direction and is perpendicular to the second direction; and
   in the function region, the driving-signal fan-out line at least partially overlaps with the second branch along the second direction, and the driving-signal fan-out line and the second branch are isolated by the first shielding portion in a region in which the driving-signal fan-out line and the second branch overlap along the second direction.

10. The display panel according to claim 4, further comprising:

   a test pin located in the function region and located on a side of the bonding pin away from the first branch;
   wherein the touch control trace further comprises an extension portion located in the function region, and two ends of the extension portion are electrically connected to the bonding pin and the test pin, respectively.

11. The display panel according to claim 1, wherein:

a test pin is located in the function region;
in the function region, the touch control trace comprises a body portion, a first branch, and a second branch, wherein the body portion is electrically connected to the touch signal line, two ends of the first branch are electrically connected to the body portion and the bonding pin, respectively, and two ends of the second branch are electrically connected to the body portion and the test pin, respectively; and
the body portion, the first branch, and the second branch each overlaps with the first shielding portion along the second direction.

12. The display panel according to claim 1, wherein:

   a test pin is located in the function region;
   the touch control trace comprises a trunk line, a first branch line, and a second branch line, wherein the trunk line is electrically connected to the touch signal line, the first branch line is electrically connected between the trunk line and the bonding pin, and the second branch line is electrically connected between the trunk line and the test pin; and
   the first branch line and the trunk line are disposed in a same layer, the second branch line and the trunk line are disposed in different layers and are electrically connected to each other through a first via, and the first branch line and the second branch line extend along different directions.

13. The display panel according to claim 12, wherein

   the trunk lines extend along the first direction and are arranged along a third direction, and the first branch lines extend along the first direction and are arranged along the third direction, the second branch lines extend along the third direction and are arranged along the first direction, and the first direction is not parallel to the third direction;
   a first center line of the function region extends along the first direction;
   at a side of the first center line, along a direction parallel to the third direction and pointing from the first center line to an edge of the display panel, lengths of the trunk lines gradually decrease, lengths of the plurality of first branch lines gradually increase, and each first via is located the respective trunk line and the respective first branch line that are connected.

14. The display panel according to claim 13, wherein

   the first branch lines overlap with the second branch lines along the second direction;

the display panel further comprises second shielding portions located between the first branch lines and the second branch lines along the second direction; and

the second shielding portions are configured to receive a fixed potential.

15. The display panel according to claim 14, wherein

the second shielding portions extend along the first direction and are arranged along the third direction; and

the second shielding portions and the second branch lines overlap along the second direction in one-to-one correspondence.

16. The display panel according to claim 15, wherein each of the second shielding portions comprises a first end and a second end that are opposite to each other along the first direction, the first ends of the second shielding portions are electrically connected to each other, and the second ends of the second shielding portions are electrically connected to each other.

17. The display panel according to claim 14, further comprising:

a power line, configured to provide a direct-current power supply to the display region; wherein the second shielding portions are electrically connected to the power line.

18. The display panel according to claim 14, further comprising:

a substrate and a plurality of metal layers disposed on a side of the substrate, wherein every pair of the metal layers adjacent along the second direction are isolated by an insulating layer; wherein:

the metal layers comprise a first metal layer, a second metal layer, a third metal layer, a first touch metal layer, and a second touch metal layer, which are arranged according to the above-listed sequence along a direction from the substrate to the light-emitting surface of the display panel; and

in the function region, the trunk lines and the first branch lines are located in the second touch metal layer, the second branch lines are located in the third metal layer, the second shielding portions are located in the first touch metal layer, the first shielding portion is located in the second metal layer, and the first signal line is located on a side of the first shielding portion facing the substrate.

19. The display panel according to claim 14, further comprising:

a substrate and a plurality of metal layers disposed on a side of the substrate, wherein every pair of the metal layers adjacent along the second direction are isolated by an insulating layer; wherein:

the metal layers comprise a first metal layer, a second metal layer, a third metal layer, a fourth metal layer, a first touch metal layer, and a second touch metal layer, which are arranged according to the above-listed sequence along a direction from the substrate to the light-emitting surface of the display panel; and

in the function region, the trunk lines and the first branch lines are located in the second touch metal layer, the second branch lines are located in the third metal layer, the second shielding portions are located in the fourth metal layer, the first shielding portion is located in the second metal layer, and the first signal line is located on a side of the first shielding portion facing the substrate.

20. The display panel according to claim 14, further comprising:

a substrate and a plurality of metal layers disposed on a side of the substrate, wherein every pair of the metal layers adjacent along the second direction are isolated by an insulating layer; wherein:

the metal layers comprise a first metal layer, a second metal layer, a third metal layer, a first touch metal layer, and a second touch metal layer, which are arranged according to the above-listed sequence along a direction from the substrate to the light-emitting surface of the display panel;

the first branch lines are located in the second touch metal layer, and the second branch lines are located in the third metal layer;

the function region comprises a jumper-wire region in which the first branch lines and the second branch lines overlap, and in the jumper-wire region, a distance between the substrate and the insulating layer at a surface of the first branch lines facing the substrate is H1;

the function region comprises a first region adjacent to the jumper-wire region, and in the first region, a distance between the substrate and the insulating layer at the surface of the first branch lines facing the substrate is H2;

$$H1<H2;$$

and
the insulating layer at the surface of the first branch lines facing the substrate comprises a slope at a junction between the jumper-wire region and the first region, and the slope rises along a direction from the jumper-wire region to the first region; and
the first branch lines extend into the first region through the slope.

21. The display panel according to claim 20, wherein:
an angle between an inclined surface of the slope and a bottom surface of the slope is $\alpha$, wherein $\alpha \leq 50°$.

22. The display panel according to claim 20, wherein:

the inclined surface of the slope has a plurality of trenches, wherein each trench extends from a bottom of the slope to a top of the slope;
the first branch lines overlap with the plurality of recesses along the second direction; and
a dimension of the first branch line is greater than a dimension of the trench along the third direction.

23. The display panel according to claim 1, wherein:
the step region further comprises a bendable region located between the trace region and the function region, and the function region is capable to be bend toward a side of the display panel facing away from the light-emitting surface using the bendable region.

24. A display apparatus, comprising the display panel according to any one of claims 1 to 23.

100

AA

A0/A2

A

A0/A1

Fig. 1

T0/TX    T0/RX

X/X1

X/X2

Fig. 2

D3

D1

T0/TX    T0/RX

X/X2

X/X1

YC

Q1

PX/PVDD

PX/PVEE

Q0

X0/ZT

X0/FZ1

Q2

FPC

91/PX    S1    SC2    SC1    B0

Fig. 3

**100**

Fig. 4

Fig. 5

PX/91   X   K

B

S1

K

B

Fig. 6

D2

B-B

K   91/PX

JY   S1   00

Fig. 7

Fig. 8

Fig. 9

Fig. 10

Fig. 11

X0/ZT

PVEE/PX

PVDD/PX

X0/FZ1

91/PX/PVEE

S1

X0/FZ2

B0

D1

FPC

D3

VT-P

VT-P

Fig. 12

ZX1

X0/ZTX

PX

X0/FZX2

KQ

K0

D1

D3

X0/FZX1

92

Fig. 13

**92**

Fig. 14

**92**

Fig. 15

Fig. 16

_92_

D1

D3

Fig. 17

D2

TM2/ZTX/FZX1    TM1/92

M1/S1    M2/91    M3/FZX2    MC    00

Fig. 18

D2

TM2/ZTX/FZX1    M4/92

M1/S1    M2    M3/FZX2    MC    00

Fig. 19

Q11

KQ

TM2/X/FZX1

α

XP

H2

H1

00

PX/M2

PX/M3

Fig. 20

TM2/X/FZX1

00

PX/M2

PX/M3

Fig. 21

Fig. 22

C-C

Fig. 23

Fig. 24

**200**

Fig. 25

## INTERNATIONAL SEARCH REPORT

| International application No. |
|---|
| **PCT/CN2024/119612** |

| A. | CLASSIFICATION OF SUBJECT MATTER |
|---|---|

H10K 59/40(2023.01)i; H10K59/126(2023.01)i; H10K59/131(2023.01)i

According to International Patent Classification (IPC) or to both national classification and IPC

| B. | FIELDS SEARCHED |
|---|---|

Minimum documentation searched (classification system followed by classification symbols)

IPC:H10K,H01L

Documentation searched other than minimum documentation to the extent that such documents are included in the fields searched

Electronic data base consulted during the international search (name of data base and, where practicable, search terms used)

CNTXT, CNABS, ENTXT, ENTXTC, DWPI, CNKI, IEEE: 显示, 面板, 触控, 触摸, 屏蔽, 遮蔽, 线, 叠, 迭, 投影, 坡, 斜面, 倾斜, 沟, 槽, 凹, display, panel, touch+, shield+, screen+, line?, wire?, wiring?, trace?, lap+, superpos+, overlay+, overlying, overlie, project+, slop+, trench+, groov+, concave

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2024044894 A1 (BOE TECHNOLOGY GROUP CO., LTD. et al.) 07 March 2024 (2024-03-07) description, page 6, line 13 to page 23, line 17, and figures 1-13 | 1-7, 23-24 |
| Y | WO 2024044894 A1 (BOE TECHNOLOGY GROUP CO., LTD. et al.) 07 March 2024 (2024-03-07) description, page 6, line 13 to page 23, line 17, and figures 1-13 | 8-22, 24 |
| Y | US 2024184388 A1 (WUHAN CHINA STAR OPTOELECTRONICS SEMICONDUCTOR DISPLAY TECHNOLOGY CO., LTD.) 06 June 2024 (2024-06-06) description, paragraphs [0053]-[0117], and figures 1-10 | 8-9, 11-22, 24 |
| Y | WO 2023205963 A1 (BOE TECHNOLOGY GROUP CO., LTD. et al.) 02 November 2023 (2023-11-02) description, page 6, line 11 to page 14, line 22, and figures 2-23 | 10, 13-22, 24 |
| Y | CN 112436047 A (HUBEI CHANGJIANG NEW DISPLAY INDUSTRY INNOVATION CENTER CO., LTD.) 02 March 2021 (2021-03-02) description, paragraphs [0005]-[0095], and figures 1-14 | 14-22, 24 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 March 2025** | **07 March 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/119612** |

| C. | DOCUMENTS CONSIDERED TO BE RELEVANT | |
| --- | --- | --- |
| Category* | Citation of document, with indication, where appropriate, of the relevant passages | Relevant to claim No. |
| Y | JP 2016180739 A (SEIKO EPSON CORP.) 13 October 2016 (2016-10-13)<br>    description, paragraphs [0087]-[0090], and figure 5 | 20-22, 24 |
| X | CN 115586850 A (XIAMEN TIANMA DISPLAY TECHNOLOGY CO., LTD.) 10 January 2023 (2023-01-10)<br>    description, paragraphs [0003]-[0056], and figures 1-13 | 1-3, 24 |
| X | CN 113282190 A (NOVATEK MICROELECTRONICS CORP.) 20 August 2021 (2021-08-20)<br>    description, paragraphs [0003]-[0096], and figures 1-8 | 1, 24 |
| A | WO 2024044893 A1 (BOE TECHNOLOGY GROUP CO., LTD. et al.) 07 March 2024 (2024-03-07)<br>    entire document | 1-24 |

Form PCT/ISA/210 (second sheet) (July 2022)

## INTERNATIONAL SEARCH REPORT
### Information on patent family members

International application No.

**PCT/CN2024/119612**

| Patent document cited in search report | | | Publication date (day/month/year) | Patent family member(s) | | | Publication date (day/month/year) |
|---|---|---|---|---|---|---|---|
| WO | 2024044894 | A1 | 07 March 2024 | US | 2025021184 | A1 | 16 January 2025 |
| | | | | EP | 4478413 | A1 | 18 December 2024 |
| US | 2024184388 | A1 | 06 June 2024 | WO | 2023221214 | A1 | 23 November 2023 |
| WO | 2023205963 | A1 | 02 November 2023 | US | 2024272741 | A1 | 15 August 2024 |
| CN | 112436047 | A | 02 March 2021 | CN | 112436047 | B | 23 August 2022 |
| JP | 2016180739 | A | 13 October 2016 | | None | | |
| CN | 115586850 | A | 10 January 2023 | | None | | |
| CN | 113282190 | A | 20 August 2021 | US | 2021278920 | A1 | 09 September 2021 |
| | | | | US | 11494016 | B2 | 08 November 2022 |
| | | | | TWM | 616261 | U | 01 September 2021 |
| WO | 2024044893 | A1 | 07 March 2024 | US | 2024393907 | A1 | 28 November 2024 |
| | | | | US | 12216869 | B2 | 04 February 2025 |
| | | | | EP | 4459445 | A1 | 06 November 2024 |

**REFERENCES CITED IN THE DESCRIPTION**

**Patent documents cited in the description**

• CN 202411204925